# EUROPÄISCHE PATENTANMELDUNG

(11) **EP 2 309 294 A2**
(43) Veröffentlichungstag der Anmeldung: **13.04.2011**
(21) Anmeldenummer: 10183725.0
(22) Anmeldetag: 28.12.2004
(51) Int. Cl.: G02B 6/43, G02B 6/122, G02B 6/42, H05K 1/02

(54) **Leiterplattenelement sowie Verfahren zur Herstellung eines Leiterplattenelements**

(30) Priorität: 29.12.2003 AT 20962003
(62) Teilanmeldung aus: 04802021.8
(71) Anmelder: AT & S Austria Technologie & Systemtechnik Aktiengesellschaft, 8700 Leoben-Hinterberg (AT)
(72) Erfinder: Leising, Günther, 8042 Graz (AT); Klamminger, Arno, 8054 Graz (AT); Langer, Gregor, 9061 Wölfnitz (AT); Schmidt, Volker, 8212 Pischelsdorf (AT); Reitzer, Riika, 8111 Judendorf-Straßengel (AT)
(74) Vertreter: Sonn & Partner Patentanwälte

(57) **Zusammenfassung**

Die Erfindung betrifft ein Leiterplattenelement (1) mit wenigstens einem in einer optischen Schicht (3) eingebetteten optoelektronischen Bauelement (4, 5; 4', 5') und mit wenigstens einem in der optischen Schicht (3) vorgesehenen Licht-Wellenleiter (6), der an das optoelektronische Bauelement (4, 5; 4', 5') anschließt, wobei eine einzelne, durch photoreaktives, Zweiphotonenabsorptions-Prozess-fähiges Material gebildete optische Schicht (3) vorgesehen ist, innerhalb von der der durch einen Zweiphotonenabsorptions-Prozess strukturierte Licht-Wellenleiter (6) eingebettet vorliegt, und wobei das bzw. wenigstens ein optoelektronische(s) Bauelement mit einer Seite an eine elektrisch leitende Verteiler- bzw. Wärmeableitschicht (21') grenzt. Weiters betrifft die Erfindung ein Verfahren zur Herstellung eines solchen Leiterplattenelements.

## Beschreibung

Die Erfindung betrifft ein Leiterplattenelement mit wenigstens einem in einer optischen Schicht eingebetteten optoelektronischen Bauelement und mit wenigstens einem in der optischen Schicht vorgesehenen Licht-Wellenleiter, der an das optoelektronische Bauelement anschließt, sowie ein Verfahren zur Herstellung eines Leiterplattenelements mit wenigstens einem in einer optischen Schicht vorgesehenen Licht-Wellenleiter und mit wenigstens einem optoelektronischen Bauelement, das mit dem Licht-Wellenleiter in optischer Verbindung steht.

In der Elektronik erhöhen sich die Geschwindigkeit und Komplexität von Elektronik-Komponenten, wie Prozessoren, rasant, und diese Zunahme der Leistung führt auch zu einer enormen Erhöhung der Datenraten, mit denen diese Elektronik-Komponenten gespeist werden und mit anderen Komponenten kommunizieren. Die Übertragung der erforderlichen hohen Datenmengen stellt eine besondere Herausforderung an die Signalverbindungen zwischen den Bauelementen dar. Um diesen Anforderungen gerecht zu werden, wurden bereits optische Signalverbindungen in Leiterplatten vorgeschlagen.

Beispielsweise offenbart die WO 01/16630 A1 ein Leiterplattenelement, welches als herkömmliche Multilayer-Leiterplatte, jedoch einschließlich einer optischen Wellenleiter-Schicht, ausgebildet ist. Im Einzelnen wird dieses bekannte Leiterplattenelement an der Außenseite in herkömmlicher Weise mit elektronischen Komponenten bestückt, und im Inneren der Leiterplattenstruktur eingebettet befinden sich optoelektronische Bauelemente in Form eines Laserelements sowie einer Photodiode, die mit den äußeren elektronischen Komponenten elektrisch verbunden sind. Diese optoelektronischen Bauelemente sind in einer Pufferschicht angrenzend an eine optische Wellenleiter-Schicht untergebracht, und in dieser optischen Wellenleiter-Schicht sind zur optischen Signalübertragung in Ausrichtung zu den optoelektronischen Bauelementen Spiegel oder Gitterstrukturen vorgesehen, um den Laserstrahl bzw. Lichtstrahl entsprechend in die optische Wellenleiter-Schicht hinein bzw. aus dieser heraus umzulenken. Von Nachteil ist dabei, dass bei der Herstellung die Ausrichtung der optoelektronischen Bauelemente und dieser Umlenkelemente kritisch ist, und dass überdies Verluste durch die passiven optischen Umlenkelemente in Kauf genommen werden müssen. Die optische Wellenleiter-Schicht besteht insbesondere aus einem Polyimid-Material, das durch eine Spinnbeschichtung aufgetragen und bei erhöhter Temperatur ausgehärtet wird, wobei flächige Licht-Wellenleitergebilde entstehen, innerhalb von denen der jeweilige Laserstrahl mit Hilfe der passiven Umlenkelemente etc. ausgerichtet wird. Wesentlich ist somit hierfür weiters, dass ein gut gebündelter Laserstrahl vom Laser-Bauelement erzeugt wird.

Es ist andererseits beispielsweise aus WO 01/96915 A2, WO 01/96917 A2 und US 4 666 236 A bereits bekannt, in einem organischen oder auch anorganischen, optischen Material, das beispielsweise in Blockform vorliegt, optische Wellenleiterstrukturen mit Hilfe von Photonen-Absorptionsprozessen zu erzeugen, wobei das optische Material lokal beim Bestrahlen mit Photonen derart umgewandelt wird, dass es einen größeren Brechungsindex aufweist, verglichen mit dem übrigen optischen Material. Die bekannten optischen Wellenleiterstrukturen werden dabei als Optokoppler-Bauelemente zum Koppeln von Lichtleiter-Kabeln untereinander oder mit optoelektronischen Bauelementen eingesetzt. Diese bekannten Optokoppler-Bauelemente können somit nur in ganz speziellen Fällen eingesetzt werden.

Ein an sich vergleichbares optisches Bauelement mit Lichtleiter, allerdings ohne optisch strukturierte Lichtleiterschicht ist in der US 4 762 381 A geoffenbart. Auch hier geht es im Wesentlichen nur um eine Technik zum Einkoppeln von Licht in den Lichtleiter, wobei eine Lichtquelle unmittelbar in das Lichtleitermatermaterial eingebettet ist.

Sodann ist es aus der EP 1 219 994 A2 bekannt, eine flächige Wellenleiterschicht in einer Halbleitervorrichtung mit plättchenförmigem Substrat einzubauen, wobei die elektrooptischen Bauelemente an der Oberfläche der Wellenleiterschicht angeordnet sind; hierbei sind jeweils nur beschränkte Anwendungen der Halbleitervorrichtungen möglich. Eine ähnliche integrierte Schaltung ist in der US 2002/0081056 A1 beschrieben, wobei eine mehrlagige optische Schicht mit einer Kernlage zwischen Mantellagen, auf einem Halbleitersubstrat, vorgesehen ist. Dabei ist ein optoelektronisches Bauelement in einer der Mantellagen, also nicht in der den eigentlichen Lichtleiter bildenden Kernlage, angeordnet.

Aus der US 2002/0028045 A1 geht weiters eine Technik von optischen Kopplungsstrukturen hervor, wobei ein optisches Bauelement mit einem Wellenleiter, der in einem optischen Material eingebettet ist, gekoppelt ist. Die optische Kopplungsstruktur enthält eine dünne metallische Schicht mit einer Öffnung, durch die das Bauelement zugänglich ist. Für den Wellenleiter sind herkömmliche Schichtaufbauten sowie auch gegebenenfalls eine Herstellung mit Hilfe von aktinischen Strahlen, also Ionenstrahlen, erläutert, und die bekannte Technik dient insbesondere zur Herstellung von Multichip-Modulen (MCMs).

Es ist nun Aufgabe der Erfindung, ein Leiterplattenelement wie eingangs angegeben sowie ein Verfahren zur Herstellung eines solchen Leiterplattenelements vorzusehen, wobei der Aufbau des Leiterplattenelements einfach und die Herstellung einfach und insbesondere unkritisch hinsichtlich der Positionierung einzelner Elemente ist und überdies im Betrieb des Leiterplattenelements optische Verluste auf ein Minimum reduziert werden.

Zur Lösung dieser Aufgabe sieht die Erfindung ein Leiterplattenelement wie in Anspruch 1 bzw. ein Verfahren zur Herstellung eines Leiterplattenelements wie in Anspruch 9 definiert vor.

Vorteilhafte Ausführungsformen und Weiterbildungen sind in den Unteransprüchen definiert.

Bei der vorliegenden Technik sind optoelektronische Bauelemente unmittelbar in der optischen Schicht eingebettet, d.h. es wird eine Oberflächen-Montage derartiger Bauelemente vermieden. In der Folge ergibt sich, dass die Positionierung der optoelektronischen Bauelemente nicht kritisch ist, und dass auch die Ausrichtung der optischen Wellenleiterstruktur vergleichsweise unkritisch ist. Da die optoelektronischen Bauelemente unmittelbar in der optischen Schicht eingebettet und die Wellenleiterstruktur somit de facto unmittelbar an diese optoelektronischen Bauelemente anschließend vorgesehen sind, ergibt sich nicht nur eine vereinfachte Struktur insofern, Spiegel, Gitter und dgl. entfallen können, sondern es wird darüber hinaus eine geringere Bauhöhe des Leiterplattenelements ermöglicht, abgesehen davon, dass Verluste durch derartige passive optische Elemente, wie Spiegel und Gitter, vermieden werden können. Es werden somit beispielsweise Multilayer-Leiterplatten mit integrierten optischen Signalverbindungen ermöglicht, die die Übertragung von großen Datenmengen zwischen Bauelementen und Modulen, wie etwa zwischen Prozessoren und Speichern, ermöglichen. Beispielsweise sind Datenübertragungsraten von weit über 10 Gbit/s erzielbar. Von Vorteil ist auch, dass einerseits herkömmliche Leiterplattentechniken, mit Kupfer-Leiterverbindungen, sowie andererseits optischen Signalverbindungen dort, wo große Datenmengen zu übertragen sind, kombiniert werden können, wobei auch Leiterplattenstrukturen insgesamt vorliegen können, die wie herkömmliche Leiterplatten, etwa ein so genanntes Motherboard, in EDV-Anlagen etc. montiert werden können.

Über die Verteiler- bzw. Wärmeableitschicht kann Wärmeenergie vom optoelektronischen Bauelement zur Außenseite abgeführt werden.

Bei der Strukturierung der Licht-Wellenleiter innerhalb der optischen Schicht kann mit Vorteil derart vorgegangen werden, dass das bereits in der optischen Schicht eingebettete optoelektronische Bauelement mit Hilfe einer Kamera oder dgl. optischen Visionseinheit anvisiert und hinsichtlich seiner Position erfasst wird; über diese Visionseinheit wird sodann eine Bestrahlungseinheit mit einem Linsensystem angesteuert, um so einerseits den Fokusbereich des abgegebenen Photonenstrahls, insbesondere Laserstrahls, in der Ebene des Leiterplattenelements, d.h. in der x/y-Ebene, zu bewegen und andererseits auch in der Tiefe innerhalb der optischen Schicht, also in der z-Richtung, einzustellen. Somit kann, mit dem jeweiligen optoelektronischen Bauelement als Bezugselement, der Licht-Wellenleiter innerhalb der optischen Schicht in der gewünschten Weise strukturiert werden, etwa als einfache geradlinige Licht-Wellenleiter-Verbindung oder aber als Wellenleiterstruktur mit Verzweigungen oder dgl. Strukturen, insbesondere auch als dreidimensionale Struktur. Die Querschnitts-Abmessungen des so struk-turierten Licht-Wellenleiters können beispielsweise in der Größenordnung von einigen Mikrometern liegen, wobei der Querschnitt eines solchen strukturierten Licht-Wellenleiters beispielsweise elliptisch bis rechteckig sein kann; die genaue Form kann durch den Photonenstrahl und dessen Fokus-Steuerung bestimmt werden.

Zur Wellenleiter-Strukturierung wird ein Zwei-Photonen-Prozess (Two Photon Absorption - TPA) angewandt, bei dem eine chemische Reaktion (z.B. Polymerisation) durch gleichzeitige Absorption von zwei Photonen aktiviert wird. Das zu strukturierende optische Material ist für die verwendete Anregungswellenlänge (z.B. Wellenlänge = 800nm) der Lichtquelle (des Lasers) transparent. Somit kommt es zu keiner Absorption und zu keinem Ein-Photonen-Prozess im Material. Im Fokusbereich des Laserstrahls ist jedoch die Intensität so hoch, dass das Material zwei Photonen (Zwei-Photonen-Prozess) (hier Wellenlänge = 400nm) absorbiert, wodurch eine chemische Reaktion aktiviert wird. Von Vorteil ist dabei, dass durch die Transparenz des optischen Materials für die Anregungswellenlänge alle Punkte im Volumen erreicht und somit problemlos dreidimensionale Strukturen in das Volumen eingeschrieben werden können. Weiters erfolgt durch nichtlineare kohärente und inkohärente physikalische Effekte eine Selbstfokussierung des Laserstrahls, wodurch sehr kleine Fokusbereiche und somit sehr kleine Strukturdimensionen erzielt werden können. Überdies ist der Zwei-Photonen-Prozess ein Einschritt-Strukturierungsprozess, wodurch Mehrfachbelichtungen, wie z.B. gemäß US 4 666 236 A, sowie nasschemische Entwicklungsschritte nicht erforderlich sind.

Derzeitige optoelektronische Bauelemente haben beispielsweise eine Höhe von 100µm, und diese Bauhöhe ergibt auch die (Mindest-) Dicke für die optische Schicht. Besonders geringe Bauhöhen können jedoch erzielt werden, wenn anstatt von vorgefertigten optoelektronischen Bauelementen, die in der optischen Schicht eingebettet werden, in situ optoelektronische Bauelemente in Dünnschichttechnik hergestellt werden.

Andererseits ist es auch denkbar, nicht nur bloße Wandler-Bauelemente als optoelektronische Bauelemente in der optischen Schicht einzubetten, also etwa ein Laserbauelement und eine Photodiode, sondern auch zugehörige elektronische Komponenten mit zu integrieren, wie etwa einen Prozessor oder einen Speicherbaustein, so dass derartige kombinierte Baueinheiten, wie insbesondere "optoelektronische Chips", ebenfalls in der optischen Schicht eingebettet sein können, wodurch gegebenenfalls eine äußere Bestückung des Leiterplattenelements vereinfacht oder aber überhaupt entfallen kann. Das Leiterplattenelement kann ein die optische Schicht tragendes Substrat aufweisen, wobei hiefür auch eine an sich herkömmliche Leiterplattenschicht, also eine Kunstharzschicht mit einer Kupfer-Innenlage und bzw. oder Kupfer-Außenlage, vorgesehen sein kann. Die optische Schicht kann auch auf der einem solchen Substrat oder einer solchen Leiterplattenschicht gegenüberliegenden Seite zusätzlich mit einer Leiterplattenschicht versehen sein, wobei eine Kupfer-Innenlage und bzw. oder eine Kupfer-Außenlage, mit entsprechender Strukturierung, vorliegen kann. Auf diese Weise werden in an sich bekannter Weise Multilayer-Leiterplattenstrukturen vorgesehen, um die jeweiligen gewünschten Schaltungsfunktionen zu erzielen.

Innen liegende, d.h. an die optische Schicht angrenzende leitende Schichten können auch als Wärmeableitschichten dienen, um Wärmeenergie vom jeweiligen optoelektronischen Bauelement nach außen abzuführen.

Die in der optischen Schicht eingebetteten optoelektronischen Baulemente können mit Vorteil über so genannte Via-Laserbohrungen kontaktiert werden, wobei diese Via-Bohrungen in an sich bekannter Weise mit metallischen Wandüberzügen, insbesondere aus Kupfer, versehen oder überhaupt mit (elektrisch) leitendem Material, insbesondere Kupfer, gefüllt werden können. Auch über diese Via-Bohrungen, insbesondere über mit leitendem Material vollständig gefüllte Via-Bohrungen, kann Wärme von den innen liegenden, eingebetteten optoelektronischen Bauelementen nach außen abtransportiert werden.

Zur Kontaktierung der eingebetteten optoelektronischen Bauelemente können jedoch auch die Innenlagen von Leiterplattenstrukturen oder -schichten, wie vorstehend angeführt, verwendet werden. In diesem Fall ist es zweckmäßig, wenn die optoelektronischen Bauelemente mit einer Seite direkt an die Innenlage einer Leiterplattenschicht grenzen. Ansonsten ist es aber selbstverständlich auch möglich, die optoelektronischen Bauelemente zur Gänze in einer optischen Schicht einzubetten, was die Strukturierung der Licht-Wellenleiter, d.h. die Steuerung des Fokuspunktes der Photonenstrahlen in der z-Richtung, erleichtert, da dann die Positionierung in der z-Richtung nicht so kritisch ist.

Bei den erfindungsgemäßen Leiterplattenelementen schließen die strukturierten Licht-Wellenleiter praktisch direkt an das jeweilige optoelektronische Bauelement an, wobei unter "direktem Anschließen" zu verstehen ist, dass keine zwischengeschalteten passiven Elemente wie Spiegel, Gitter oder dgl. vorliegen. Es kann jedoch durchaus sein, dass in einzelnen Fällen der jeweilige Licht-Wellenleiter unter Belassung eines geringen Abstandes, etwa in der Größenordnung von 0,5µm oder 1µm, zum optoelektronischen Bauelement hergestellt wird, wobei nichtsdestoweniger ein "Einfangen" des vom optoelektronischen Bauelement abgegebenen Lichts oder ein Einkoppeln des übertragenen Lichts in das benachbarte optoelektronische Bauelement ohne namhafte optische Verluste möglich ist. Es ist weiters auch denkbar, eine photonische Lichtbeugungs-Kristallstruktur am Ende des Licht-Wellenleiters als Übergang zum optoelektronischen Bauelement vorzusehen, um so mit dieser photonischen Kristallstruktur eine möglichst optimale Lichtkonzentration zu erzielen. Andere Möglichkeiten zum Anschließen des Licht-Wellenleiters an das optoelektronische Bauelement bestehen noch darin, dass das Licht-Wellenleiter-Ende trichterförmig aufgeweitet ist oder aber dass es das optoelektronische Bauelement zumindest teilweise, gegebenenfalls aber auch zur Gänze, umschließt.

Es ist ferner im Rahmen der Erfindung möglich, das vorliegende Leiterplattenelement als flexibles Leiterplattenelement, also ohne steifes Substrat oder dgl., sondern im Wesentlichen nur als beispielsweise zweilagige optische Schicht mit zumindest einem zur Gänze eingebetteten optoelektronischen Bauelement und seitlichen Anschlüssen hiefür, vorzusehen, wobei ein derartiges flexibles Leiterplattenelement in der Folge beispielsweise an einem Träger, wie einer Gehäusewand eines elektrischen Gerätes, angebracht, z.B. aufgeklebt, werden kann.

Vorteilhafte Merkmale sind weiters:
- dass an zumindest einer Seite der elektrisch isolierenden optischen Schicht eine Leiterplattenschicht mit einer strukturierten leitenden Innenlage und bzw. oder Außenlage aufgebracht ist;
- dass das optoelektronische Bauelement bzw. gegebenenfalls die Baueinheit über Via-Bohrungen in der optischen Schicht sowie gegebenenfalls einer auf dieser aufgebrachten Leiterplattenschicht kontaktiert ist;
- dass auf der Leiterplattenschicht eine mit dem optoelektronischen Bauelement verbundene elektronische Komponente angebracht ist;
- dass das optoelektronische Bauelement ein durch Dünnschichttechnik in situ hergestelltes Bauelement ist; und
- dass das optoelektronische Bauelement ein VCSEL-Laserbauelement ist, an das der Licht-Wellenleiter, z.B mit einem bogenförmigen Übergang, anschließt.

Die Erfindung wird nun nachfolgend anhand von bevorzugten Ausführungsbeispielen, auf die sie jedoch nicht beschränkt sein soll, und unter Bezugnahme auf die Zeichnung noch weiter erläutert. Es zeigen im Einzelnen:
Fig. 1 einen schematischen Querschnitt durch ein Leiterplattenelement;
die Fig. 2 bis 7 verschiedene Herstellungsstufen bei der Herstellung eines Leiterplattenelements wie in Fig. 1 dargestellt;
Fig. 8 ein erfindungsgemäßes Leiterplattenelement in einer schematischen Querschnittsdarstellung ähnlich jener von Fig. 1;
Fig. 9 ein anderes Leiterplattenelement im Querschnitt;
Fig. 10 eine andere Ausführungsform eines Leiterplattenelements gemäß der Erfindung in einer Querschnittsdarstellung, wobei verschiedene Ausbildungsmöglichkeiten kombiniert sind;
Fig. 11 in einer Querschnittsdarstellung vergleichbar jener gemäß Fig. 5 ein Leiterplattenelement mit einer Zwischenschicht zwischen Substrat und optischer Schicht;
Fig. 12 in einer Darstellung ähnlich Fig. 3 eine Zwischenstufe bei der Herstellung eines Leiterplattenelements, bei dem anstatt der Einbettung von vorgefertigten optoelektronischen Bauelementen eine Herstellung von optoelektronischen Bauelementen in situ in Dünnfilmtechnik vorgesehen ist;
die Fig. 13A und 13B in einer ähnlichen Querschnittsdarstellung ein flexibles Leiterplattenelement (Fig. 13B), wobei in Fig. 13A noch ein im Zuge der Herstellung verwendetes Substrat ersichtlich ist, welches anschließend entfernt wird;
Fig. 14 ein vereinfachtes Leiterplattenelement im Querschnitt, mit einem einzelnen optoelektronischen Bauelement, wobei zur besseren Veranschaulichung auch der Übergang zwischen dem optoelektronischen Bauelement und dem strukturierten Licht-Wellenleiter herausgezeichnet ist;
Fig. 15 schematisch im Querschnitt ein Leiterplattenelement mit einem VCSEL-Laser und einem entsprechend strukturierten Licht-Wellenleiter;
die Fig. 16A bis 16F schematisch verschiedene Möglichkeiten für den Anschluss eines strukturierten Licht-Wellenleiters an ein optoelektronisches Bauelement; und
die Fig. 17, 18 und 19 schematische Draufsichten verschiedener Möglichkeiten zur Ausbildung von Strukturen mit optoelektronischen Bauelementen und strukturierten Licht-Wellenleitern.

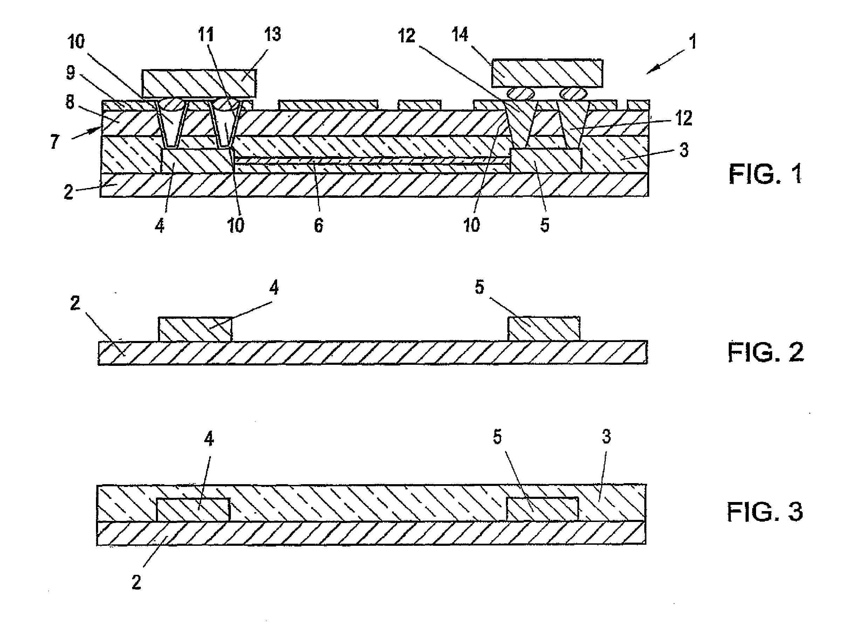

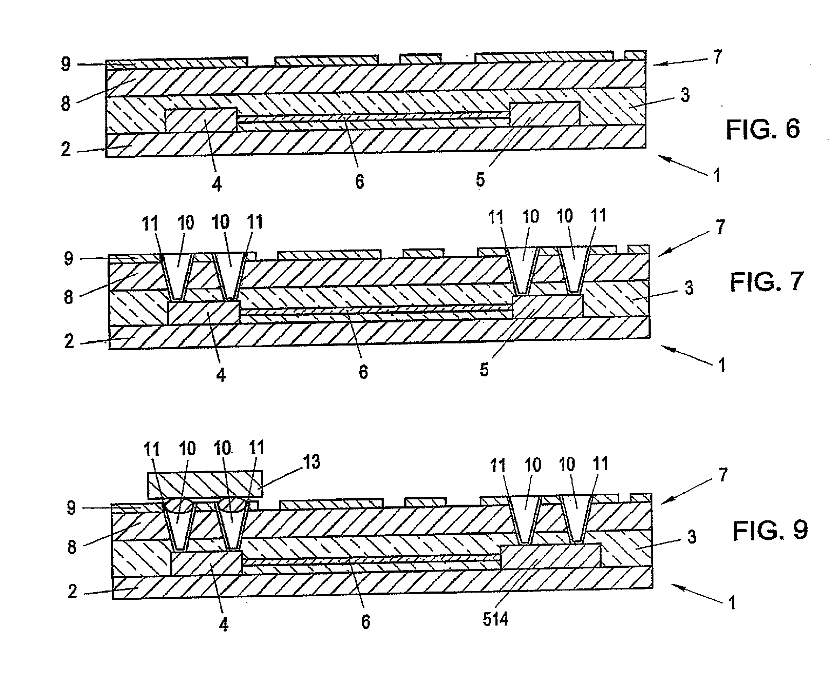

In Fig. 1 ist ganz schematisch in einem nicht maßstäblichen Querschnitt ein Aufbau eines Leiterplattenelements 1 gezeigt, wobei auch bereits eine Bestückung mit äußeren Bauelementen veranschaulicht ist; es sei aber darauf hingewiesen, dass eine derartige Bestückung mit Bauelementen in der Regel erst unmittelbar vor dem Einbau in ein Gerät, bei einem Gerätehersteller, erfolgt, und dass unbestückte Leiterplattenelemente, etwa wie aus Fig. 7 ersichtlich, in den Vertrieb gelangen. Unter "Leiterplattenelemente" sind daher auch solche ohne äußere Bestückung zu verstehen, ebenso solche, bei denen eine derartige äußere Bestückung überhaupt nicht erfolgt, vgl. z.B. auch Fig. 9 rechts.

Das in Fig. 1 schematisch veranschaulichte Leiterplattenelement 1 weist ein Substrat 2 auf, wie etwa ein herkömmliches FR4-Substrat enthaltend eine Epoxidharzschicht. Über diesem Substrat 2 befindet sich eine optische Schicht 3, die für die beim nachfolgend noch näher beschriebenen Herstellungsvorgang bzw. für die im Betrieb verwendeten Wellenlängen zumindest im Wesentlichen transparent ist und beispielsweise aus einem anorganischen oder organischen Material besteht. Ein bekanntes optisches Material, das sich für die vorliegenden Leiterplattenelemente 1 gut eignet, ist ein anorganisch-organisches Hybridmaterial, z.B. ein organisch modifiziertes Keramikmaterial, welches mittels eines Sol-Gel-Prozesses hergestellt wird. Ein anderes bekanntes Material ist ein anorganisch-organisches Hybridglas, welches ebenfalls in einem Sol-Gel-Prozess hergestellt wird und mit einem Photoinitiator (Benzyldimethylketal) gedopt ist. Dieses Hybridglas besteht aus Methylacrylat mit einem Silica/Zirkonia-Netzwerk. Weitere bekannte Materialien sind photosensitive Imide bzw. Polyimide und Organo-Silsesquioxane.

In dieser optischen Schicht 3 sind im gezeigten Beispiel von Fig. 1 zwei optoelektronische Bauelemente 4, 5 eingebettet, wobei diese beiden Bauelemente 4, 5 auf dem Substrat 2 aufliegen und im Übrigen vom Material der optischen Schicht 3 umschlossen sind. Zwischen den beiden optoelektronischen Bauelementen 4, 5 erstreckt sich ein durch lokale Strukturierung, nämlich durch lokale Polymerisation unter Zuführung von Lichtenergie, strukturierter Licht-Wellenleiter 6. Im Einzelnen kann es sich bei dem Bauelement 4 beispielsweise um eine Laserdiode handeln, wogegen das Bauelement 5 ein Photodetektor, d.h. eine Photodiode, sein kann.

Oberhalb der optischen Schicht 3 ist eine Leiterplattenschicht 7, nämlich eine Epoxidharzschicht 8 oder dgl. Isolierschicht, z.B. mit einer elektrisch leitenden, gemäß Fig. 1 bereits strukturierten Außenlage 9, üblicherweise aus Kupfer, vorgesehen. Durch diese Leiterplattenschicht 7 sowie auch das oberhalb der Bauelemente 4, 5 befindliche optische Material der optischen Schicht 3 hindurch werden die optoelektronischen Bauelemente 4, 5 über Mikro-Via(µVia)-Laserbohrungen 10 kontaktiert, wobei die Innenwände dieser Mikro-Via-Bohrungen 10 entweder mit einem Kupferbelag 11 oder mit einer Kupfer-Füllung 12 versehen sein können. Über dieses Kupfermaterial in den µVia-Bohrungen 10 wird die elektrische Verbindung zwischen den optoelektronischen Bauelementen 4, 5 einerseits und der strukturierten Außenlage 9 bzw. am Leiterplattenelement 1 aufgebrachten äußeren elektronischen Komponenten 13, 14 andererseits hergestellt, wobei diese Komponenten 13, 14, beispielsweise angelötet oder aber mit Hilfe eines leitenden Klebers, wie an sich bekannt, am Leiterplattenelement 1 angebracht werden. Bei den äußeren Komponenten 13, 14 kann es sich beispielsweise um einen Prozessor-Baustein 13 bzw. einen Speicherbaustein 14 handeln, wobei der Prozessor-Baustein 13 über die optische Signalverbindung, die durch die Elemente 4, 6 und 5 gebildet ist, in den Speicherbaustein 14 Daten einschreibt; zum Auslesen von Daten kann eine ähnliche optische Signalverbindung (in umgekehrter Richtung; nicht dargestellt) vorliegen.

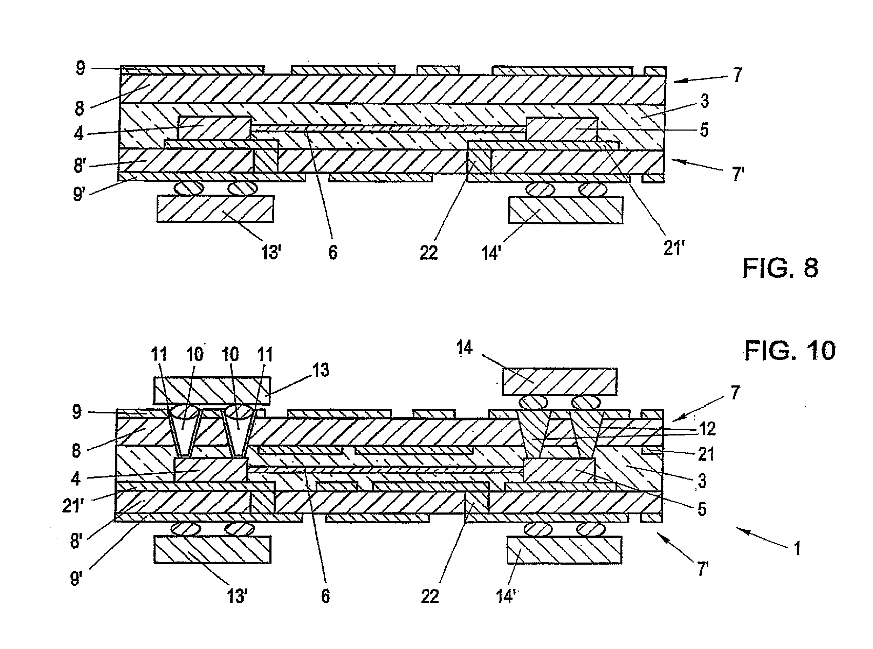

Im Fall der Füllung der Mikro-Via-Bohrungen 10 mit Kupfer, wie in Fig. 1 bei 12 gezeigt, wird der Vorteil erzielt, dass eine gute Wärmeabfuhr von den eingebetteten optoelektronischen Bauelementen, wie in Fig. 1 im Fall des rechts dargestellten Bauelements 5, zur oberen Schicht erzielt wird. Wie nachstehend noch näher, etwa anhand der Fig. 8, erläutert werden wird, können jedoch zur Wärmeabfuhr zusätzlich oder anstatt dessen auch noch andere Maßnahmen, falls gewünscht, getroffen werden.

Einzelne Schritte zur Herstellung eines Leiterplattenelements 1, wie in Fig. 1 gezeigt, sind in den Fig. 2 bis 7 dargestellt, und anhand dieser Fig. 2 bis 7 soll daher nunmehr beispielhaft ein Verfahren zur Herstellung eines solchen Leiterplattenelements erläutert werden.

Gemäß Fig. 2 wird von einem Substrat 2, wie etwa dem bereits erwähnten FR4-Substrat mit Epoxidharz, ausgegangen, und auf diesem Substrat werden die optoelektronischen Bauelemente 4, 5, wie etwa eine Laserdiode und eine Photodiode, aufgebracht, z.B. aufgeklebt.

Danach wird, wie in Fig. 3 gezeigt, Material für die optische Schicht 3 auf dem Substrat 2 aufgebracht, wie etwa durch Vergießen oder Spincoaten (Aufschleudern), wie an sich bekannt. Diese optische Schicht 3 besteht aus einem photoreaktiven Polymer etc., wie vorstehend bereits erläutert, wobei durch Photonenbestrahlung das Material lokal derart umgewandelt wird, dass es einen vergleichsweise höheren Brechungsindex erhält.

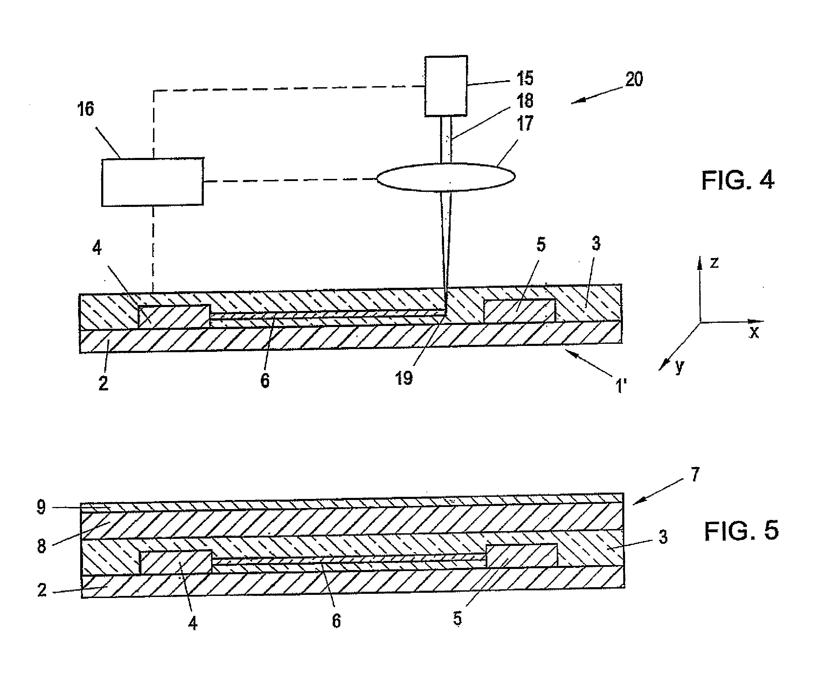

Diese lokale Umwandlung des photoreaktiven Materials der optischen Schicht 3 mit Hilfe von Photonenstrahlen ist schematisch in Fig. 4 als nächster Schritt veranschaulicht. Dabei ist eine Lichtquelle 15, wie etwa eine Laserquelle, ersichtlich, welche mit einer Visionseinheit 16 gekoppelt ist, und welcher ein Linsensystem 17 zur Fokussierung des abgegebenen Laserstrahls 18 in einem Fokusbereich 19 innerhalb des Materials der optischen Schicht 3 vorgeordnet ist.

Im Einzelnen werden bei dieser Strukturierung der optischen Schicht 3 durch die Visions- oder Visiereinheit 16, ausgehend von beispielsweise dem einen optoelektronischen Bauelement 4, dessen Koordinaten erfasst werden, die Abstände auf der durch das Leiterplattenelement (soweit bereits vorhanden) gegebenen Probe 1' vermessen, und es wird die relative Bewegung zwischen dieser Probe 1' und dem durch die Laserquelle 15 und das Linsensystem 17 gegebenen Belichtungssystem 20 gesteuert, und zwar nicht nur in der Ebene der Probe 1', also in x- bzw. y-Richtung, sondern auch in Dickenrichtung der Probe 1', also in z-Richtung, um so den Fokusbereich des Laserstrahls 18 an der gewünschten Stelle innerhalb der optischen Schicht 3 zu erhalten. Bevorzugt wird die Probe 1' in den drei Richtungen x, y und z bewegt, um den Fokusbereich 19 in der gewünschten Weise relativ zur Probe 1' innerhalb von dieser zu bewegen und so durch die Photonenbestrahlung das optische Material lokal umzuwandeln; auf diese Weise wird der strukturierte Licht-Wellenleiter 6 gebildet. Im Fokusbereich 19 ist nämlich die Intensität des Laserlichts so hoch, dass es zu einem Zweiphotonenabsorptions-Prozess, wie an sich bekannt, kommt. Durch diesen Prozess reagiert (polymerisiert) das optische Material der optischen Schicht 3, so dass der Licht-Wellenleiter 6 gebildet wird, der einen größeren Brechungsindex aufweist, verglichen mit dem ihn umgebenden Material der optischen Schicht 3. Dadurch wird ein Licht-Wellenleiter 6 ähnlich einem Lichtleiterkabel erhalten, wo im Fall einer Lichtübertragung durch entsprechende Reflexionen des Lichts an der Grenzfläche: Licht-Wellenleiter 6 umgebendes Material eine gebündelte Lichtübertragung ohne nennenswerte optische Verluste erzielt wird.

Im nächsten Schritt wird die obere Leiterplattenschicht 7 mit einer Epoxidharzschicht 8 und eine Kupfer-Außenlage 9, insbesondere durch Verpressen, auf der optischen Schicht 3 aufgebracht, und das Ergebnis dieses Verfahrensschrittes ist in Fig. 5 veranschaulicht.

Danach wird gemäß Fig. 6 die Kupfer-Außenlage 9 durch einen herkömmlichen photolithografischen Prozess in der gewünschten Weise strukturiert, um die je nach Verwendungszweck des Leiterplattenelements 1 erforderlichen Leiterbahnen und Anschlussflächen zu erzielen. (Wie bekannt wird bei einem derartigen photolithografischen Strukturierungsprozess zunächst ein Photoresistlack aufgebracht, der über eine Photomaske belichtet und sodann entwickelt wird, wonach beispielsweise die nicht durch den umgewandelten Photoresistlack geschützten Kupferbereiche weggeätzt werden; schließlich wird der restliche Resist-Lack entfernt.)

Gemäß Fig. 7 werden schließlich mit Hilfe von Laserstrahlen die Mikro-Via-Bohrungen 10 angebracht und an den Innenwänden verkupfert, d.h. mit dem Kupferbelag 11 versehen. Gegebenenfalls können die Via-Bohrungen 10 aber auch, wie anhand der Fig. 1 erläutert, mit Kupfermaterial gefüllt werden, um so abgesehen von der elektrisch leitenden Verbindung auch eine verbesserte Wärmeabfuhr durch eine solche Kupfer-Füllung 12 zu erhalten.

Damit ist ein Leiterplattenelement 1 ohne Bestückung erhalten. Wie erwähnt ist in Fig. 1 ein entsprechendes, bereits bestücktes Leiterplattenelement 1 gezeigt. Dabei erfolgt gemäß diesem Ausführungsbeispiel die Bestückung mit den äußeren elektronischen Komponenten 13, 14 an der, gemäß Darstellung in der Zeichnung, oberen Seite des Leiterplattenelements 1, was jedoch nur als Beispiel zu verstehen ist. Theoretisch denkbar ist auch, anstatt dessen oder aber zusätzlich eine Bestückung an der Unterseite des Leiterplattenelements 1 vorzusehen, wobei in diesem Fall als Substrat 2 ebenfalls eine herkömmliche Leiterplattenschichtstruktur, wie etwa ein FR4-Substrat, mit einer Außenlage aus Kupfer, verwendet wird, vgl. Fig. 8.

Zusätzlich kann eine derartige Leiterplattenschicht, wie die Leiterplattenschicht 7' in Fig. 8, auch an ihrer Oberseite mit einer Verteilerschicht 21' oder Innenlage, abgesehen von der Epoxidharzschicht 8' und der Außenlage 9', versehen sein. Diese Verteilerschicht 21', die durch vergleichbare photolithografische Strukturierung in ihrer endgültigen Form erhalten werden kann, wird dabei nicht nur für die in Fig. 8 gezeigte Herstellung der elektrischen Anschlüsse der optoelektronischen Bauelemente 4 und 5 verwendet (wobei der Vorteil erzielt wird, dass die genaue Positionierung der Verbindungsbohrungen, wie im Fall der Mikro-Via-Bohrungen 10, vermieden werden kann, da nicht die integrierten Bauelemente 4, 5 selbst, sondern nur die Verteilerschicht 21 kontaktiert werden muss), sondern es wird überdies auch eine vorteilhafte Möglichkeit zur Wärmeabfuhr geschaffen. Die innen liegende Verteilerschicht 21' wird dabei durch mit Kupfer gefüllte Bohrungen 22, die an mehr oder weniger beliebigen Stellen, nämlich dort wo Platz vorhanden ist, vorgesehen werden können, mit der Außenlage 9' verbunden. An dieser Außenlage 9' werden schließlich die äußeren elektronischen Komponenten, z.B. wiederum ein Prozessor-Baustein 13' und ein Speicherbaustein 14', angebracht.

Es ist auch denkbar, elektronische Komponenten, also Komponenten, die elektronische Daten im weitesten Sinne empfangen, verarbeiten und weiterleiten, mit dem optoelektronischen Bauelement, das im Wesentlichen eine optisch/elektrische Datenumwandlung (in welche Richtung auch immer) bewerkstelligt, zu einer Baueinheit zusammenzufassen; In Fig. 9 ist die Einbettung einer solchen Baueinheit 514 gezeigt, die beispielsweise eine Kombination des optoelektronischen Bauelements 5 und der äußeren elektronischen Komponente 14 beinhaltet. Auf diese Weise ist ein optoelektronischer Chip direkt in die optische Schicht 3 eingebettet, wobei in diesem Chip sowohl optische als auch elektronische Daten verarbeitet werden können, und es erübrigt sich somit eine nachfolgende außenseitige Bestückung bzw. wird an der Außenseite des Leiterplattenelements 1 Platz für andere Bauelemente gewonnen. Die Baueinheit 514 kann wiederum durch Mikro-Via-Bohrungen 10, mit Metallbeschichtung 11, mit einer Kupfer-Außenlage 9 verbunden sein, um die elektrischen Anschlüsse herzustellen. Im Übrigen ist die Ausführungsform gemäß Fig. 9 gleich jener gemäß Fig. 1, so dass sich eine weitere Erläuterung hievon erübrigen kann.

In Fig. 10 ist sodann eine Kombination der vorstehend anhand der Fig. 1 und 8 erläuterten Ausführungs- und Bestückungsmöglichkeiten gezeigt; es ist somit bei dieser Ausführungsform eine obere Leiterplattenstruktur 7 mit Außenlage 9 und Innenlage 21 sowie eine untere Leiterplattenstruktur 7' mit Außenlage 9' und Innenlage 21' und dazwischen die optische Schicht 3 vorhanden, und die Bestückung des so modifizierten Leiterplattenelements 1 mit elektronischen Komponenten 13, 14 bzw. 13', 14' erfolgt sowohl an der oberen Außenseite als auch an der unteren Außenseite. Im Übrigen sind wiederum optoelektronische Bauelemente 4, 5 in der optischen Schicht 3 eingebettet und durch einen lokal strukturierten Licht-Wellenleiter 6, wie vorstehend beschrieben, unmittelbar, ohne Zwischenschaltung irgendwelcher passiver optischer Elemente, miteinander verbunden.

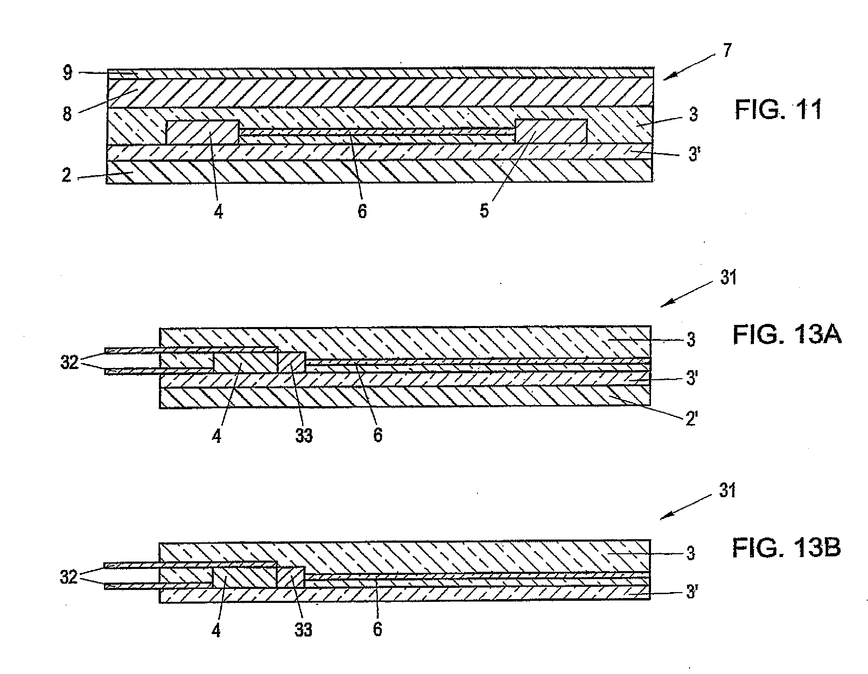

In Fig. 11 ist in einer Darstellung ähnlich jener von Fig. 5 in Abweichung von Fig. 5 eine Zwischenschicht 3' auf dem Substrat 2 gezeigt, und erst auf dieser Zwischenschicht 3' ist die optische Schicht 3 angebracht. Die optoelektronischen Bauelemente 4, 5 liegen auf der Zwischenschicht 3' auf und sind im Übrigen wiederum in die optische Schicht 3 eingebettet. Auf dieser optischen Schicht 3 befindet sich wieder eine Leiterplattenstruktur 7 mit einer Epoxidharzschicht 8 und einer Kupfer-Außenlage 9. Die Zwischenschicht 3' kann ein leitendes oder aber isolierendes, insbesondere auch photoreaktives optisches Material sein, wobei im letzteren Fall die beiden Schichten 3, 3' zusammen eine optische Schicht 3-3' ergeben, in deren Material die optoelektronischen Bauelemente 4, 5 allseitig eingebettet sind. Zwischen den optoelektronischen Bauelementen 4, 5 erstreckt sich gemäß Fig. 11 wiederum der lokal strukturierte Licht-Wellenleiter 6.

In Abwandlung hievon ist es selbstverständlich auch denkbar, die optoelektronischen Bauelemente 4, 5 auf dem Substrat 2 anzubringen und anschließend die - optische - Zwischenschicht 3' sowie die Schicht 3 aufzubringen.

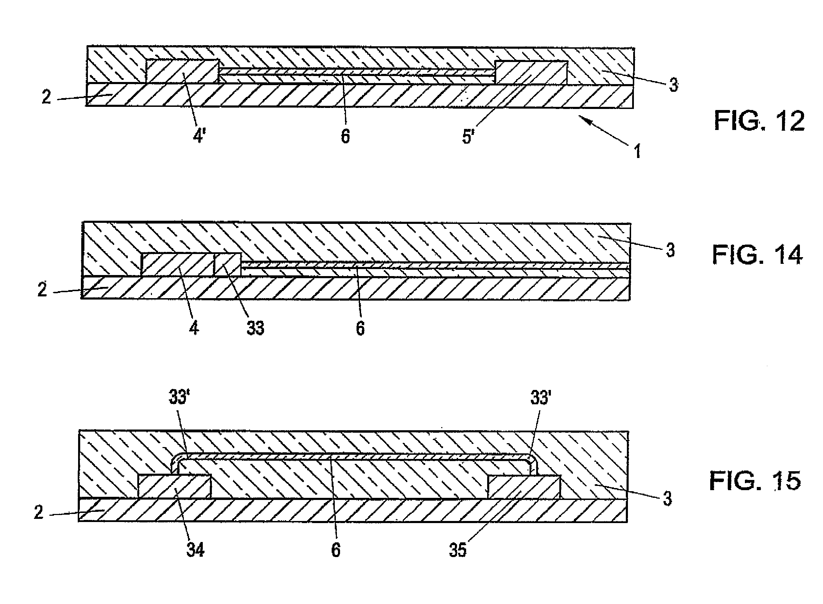

In Fig. 12 ist in einer Darstellung ähnlich Fig. 4 ein modifiziertes Leiterplattenelement 1, mit einem unteren Substrat 2, jedoch ohne obere Leiterplattenstruktur gezeigt, wobei nun abweichend von der ersten Ausführungsform die in eine optische Schicht 3 eingebetteten optoelektrischen Bauelemente 4', 5' durch Dünnschichttechnik-Bauelemente gebildet sind. Diese Dünnschicht-Bauelemente 4', 5' werden an Ort und Stelle durch an sich bekannte Prozesse auf dem Substrat 2 aufgebaut, bevor die optische Schicht 3 angebracht und in dieser optischen Schicht 3 sodann auf die vorstehend beschriebene Weise der Licht-Wellenleiter 6 durch Photonen-Bestrahlung strukturiert vorgesehen wird. Die weitere Ausführung kann sodann ähnlich wie vorstehend anhand der Fig. 5 bis 7, der Fig. 8, usw. erfolgen, es ist jedoch durchaus auch denkbar, ein Leiterplattenelement 1 ohne äußere Leiterplattenstrukturen, mit einer Kupfer-Außenlage und/oder -Innenlage, vorzusehen, und insbesondere auch ohne Bestückung mit elektronischen Komponenten an der oberen und/oder unteren Außenseite.

So ist ein einfaches, flexibles Leiterplattenelement 31 in Fig. 13B gezeigt, wobei dieses Leiterplattenelement 31 zuvor auf einem in Fig. 13A ersichtlichen Träger-Substrat 2' aufgebaut wird. Das Leiterplattenelement 31 kann mit einer Zwischenschicht 3' und der optischen Schicht 3 ausgeführt sein, wobei auch der Zwischenschicht 3' eine optische Schicht, aus vergleichbarem transparenten, optischen, photoreaktiven Material, sein kann, aber auch durch eine andere Kunststoffschicht gebildet sein kann. Das Substrat 2, das in Fig. 13A ersichtlich ist, wird nach der Herstellung des Leiterplattenelements 31 entfernt, so dass eine flexible Lage erhalten wird, die durch die Schichten 3, 3' gegeben ist und die sehr dünn, in der Art einer Folie, sein kann. Dieses flexible Leiterplattenelement 31 kann auf einem Untergrund, wie etwa der Innenseite eines Gehäuses eines elektrischen Gerätes, aufgebracht werden, um dort den Platz für elektrische Schaltungen zu nützen.

Im Beispiel von Fig. 13A und 13B ist nur ein einzelnes optoelektronisches Bauelement 4 dargestellt, das auf der Zwischenschicht 3' aufgebracht wird; vor Anbringen der optischen Schicht 3 auf die anhand der Fig. 3 vorstehend erläuterte Weise werden zum optoelektronischen Bauelement 4 Anschlüsse 32, beispielsweise durch Bonden mit Kupferdraht, hergestellt.

Weiters ist in Fig. 13A und 13B gezeigt, dass der Licht-Wellenleiter 6, der wiederum wie anhand der Fig. 4 erläutert hergestellt wird, über einen Übergangsbereich 33, ein "Interface", an das optoelektronische Bauelement 4 anschließt, wobei dieser Übergangsbereich 33 gleichzeitig mit dem Licht-Wellenleiter 6 durch die beschriebene Photonenbestrahlung hergestellt wird.

Ein vergleichbarer Übergangsbereich 33 ist auch in der Ausführungsform gemäß Fig. 14 veranschaulicht, wobei dort eine Zweischicht-Struktur mit Substrat 2 und optischer Schicht 3 gezeigt ist, und wobei ebenfalls nur ein einzelnes optoelektronisches Bauelement 4 veranschaulicht ist, an das der Licht-Wellenleiter 6 über diesen Übergangsbereich 33 anschließt. Das Substrat 2 kann hier eine nicht näher gezeigte Außen- und/oder Innenlage aus leitendem Material aufweisen.

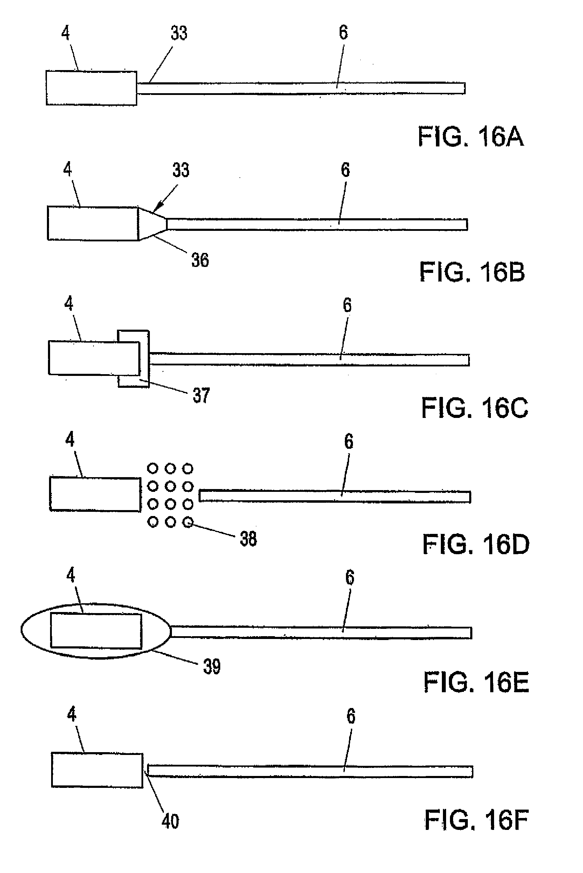

Bevor nun verschiedene Möglichkeiten für eine Ausbildung eines solchen Übergangsbereiches 33 anhand der Fig. 16A-16F erläutert werden, wird noch auf Fig. 15 verwiesen, in der eine Ausbildung mit einem VCSEL-Laserelement 34 (VCSEL - Vertical-cavity surface emitting laser) als optoelektronisches Bauelement sowie einer oberseitig mit der Lichtempfangsseite ausgerüsteten Photodiode 35 gezeigt ist, wobei hier der Licht-Wellenleiter 6 über bogenförmige Übergangsbereiche 33' an diese beiden optoelektronischen Bauelemente 34, 35 - die wiederum in der beschriebenen Weise in einer auf einem Substrat 2 angebrachten optischen Schicht 3 eingebettet sind - anschließt.

In Fig. 16 sind nun in den Teilfiguren 16A bis 16F verschiedene Ausbildungsmöglichkeiten für das an das optoelektronische Bauelement, z.B. 4, anschließende Ende (Übergangsbereich 33) des Licht-Wellenleiters 6 schematisch veranschaulicht. Gemäß Fig. 16A wird der Licht-Wellenleiter 6 bis direkt zum Bauelement 4 reichend "eingeschrieben", um so eine scharfe Kante am Ende des Licht-Wellenleiters 6 herbeizuführen. Gemäß Fig. 16B wird der Licht-Wellenleiter 6 an seinem Ende bzw. im Übergangsbereich 33 zu einem Trichter 36 aufgeweitet, und gemäß Fig. 16C wird der Licht-Wellenleiter 6 im Übergangsbereich direkt um das optoelektronische Bauelement 4 herum "eingeschrieben", wobei ein teilweises Umschließen im Anschlussbereich 37 erhalten wird.

Gemäß Fig. 16D wird am Ende des Licht-Wellenleiters 6 im Zuge der beschriebenen Photonenbestrahlung eine photonische Kristallstruktur 38 (mit Säulen etc., mit einer Periodizität in zwei Dimensionen oder in drei Dimensionen) eingeschrieben, wobei diese Kristallstruktur - die an sich von ihrer Wirkung her bekannt ist - das Licht auf einen mittigen Durchgang beschränkt und so einen optischen Anschluss vom Bauelement 4 zum Licht-Wellenleiter 6 oder umgekehrt mit außerordentlich geringen Verlusten ermöglicht.

Gemäß Fig. 16E wird das optoelektronische Bauelement 4 nicht nur teilweise, wie gemäß Fig. 16C, sondern zur Gänze vom Licht-Wellenleiter-Ende, wie bei 39 gezeigt, umschlossen. Man könnte daher auch die Ausführungsbeispiele gemäß Fig. 16B und 16C als Sonderfälle von 16E ansehen.

In Fig. 16F ist schließlich gezeigt, dass es auch zulässig ist, einen - geringen - Zwischenraum oder Spalt 40 zwischen dem Bauelement 4 und dem Licht-Wellenleiter 6 zu belassen, etwa wenn beim "Einschreiben" des Licht-Wellenleiters 6, wie anhand der Fig. 4 vorstehend erläutert, der Laserstrahl nicht unmittelbar am Bauelement 4 fokussiert werden darf. Ein derartiger Spalt 40 kann, ohne dass eine Beeinträchtigung der Funktion erfolgt, in der Größenordnung von beispielweise 1µm liegen.

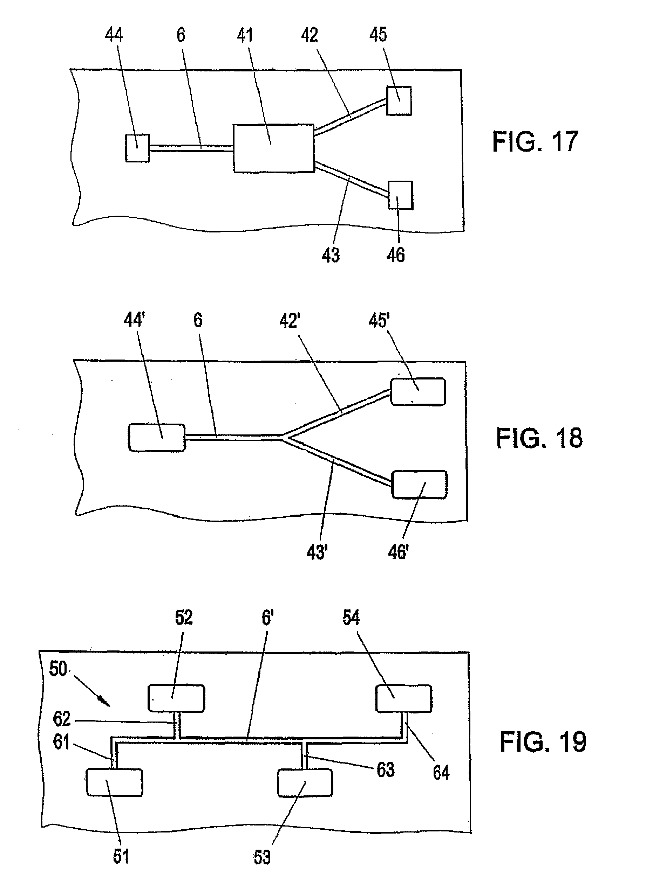

Abschließend werden anhand der Fig. 17, 18 und 19 noch einzelne Beispiele für im erfindungsgemäßen Leiterplattenelement realisierbare optische Signalverbindungen einschließlich optoelektronischer Bauelemente erläutert. Es sei aber darauf hingewiesen, dass selbstverständlich zahlreiche andere Möglichkeiten für derartige optische Signalverbindungen mit optoelektronischen Bauelementen und strukturierten Licht-Wellenleitern gegeben sind.

In Fig. 17 ist beispielsweise eine Y-Konfiguration für eine optische Signalverbinung gezeigt, wobei an der Knotenstelle beispielsweise ein Multiplexer-/Demultiplexer-Bauelement 41 im Anschluss an einen Licht-Wellenleiter 6 sowie andererseits Licht-Wellenleiter 42, 43 gezeigt ist, um so optoelektronische Bauelemente 44 einerseits bzw. 45, 46 andererseits miteinander zu verbinden.

Auch in Fig. 18 ist eine Y-Konfiguration mit zwei kombinierten optoelektronischen Prozessor- bzw. Speicher-Baueinheiten 45', 46' einerseits und einer Baueinheit 44' andererseits gezeigt, wobei der von der Baueinheit 44' wegführende Licht-Wellenleiter 6 in zwei Zweige 42', 43' aufgezweigt ist.

In Fig. 19 ist schließlich ein optisches Bussystem mit optoelektronischen Sende-/Empfangs-Baueinheit 51, 52, 53 und 54 gezeigt, wobei das optische Bussystem 50 einen Haupt-Licht-Wellenleiter 6' und davon abzweigende Licht-Wellenleiter 61, 62, 63 und 64 enthält.

## Patentansprüche

1. Leiterplattenelement (1) mit wenigstens einem in einer optischen Schicht (3) eingebetteten optoelektronischen Bauelement (4, 5; 4', 5') und mit wenigstens einem in der optischen Schicht (3) vorgesehenen Licht-Wellenleiter (6), der an das optoelektronische Bauelement (4, 5; 4', 5') anschließt, **dadurch gekennzeichnet, dass** eine einzelne, durch photoreaktives, Zweiphotonenabsorptions-Prozess-fähiges Material gebildete optische Schicht (3) vorgesehen ist, innerhalb von der der durch einen Zweiphotonenabsorptions-Prozess strukturierte Licht-Wellenleiter (6) eingebettet vorliegt, und dass das bzw. wenigstens ein optoelektronische(s) Bauelement mit einer Seite an eine elektrisch leitende Verteiler- bzw. Wärmeableitschicht (21') grenzt.

2. Leiterplattenelement nach Anspruch 1, **dadurch gekennzeichnet, dass** die Verteiler- bzw. Wärmeableitschicht (21') durch eine strukturierte Innenlage gebildet ist.

3. Leiterplattenelement nach Anspruch 1 oder 2, **dadurch gekennzeichnet, dass** das optoelektronische Bauelement (4, 5; 4', 5') mit einer Seite an ein die optische Schicht (3) tragendes Substrat (2) bzw. eine darauf angebrachte Überzugsschicht (3'; 21) angrenzt.

4. Leiterplattenelement nach einem der Ansprüche 1 bis 3, **dadurch gekennzeichnet, dass** das optoelektronische Bauelement (4, 5; 4', 5') allseitig in der, z.B. in zwei Lagen ausgeführten, optischen Schicht (3, 3') eingebettet ist, wobei die optische Schicht (3, 3') beispielsweise als flexible Lage ausgebildet ist.

5. Leiterplattenelement nach einem der Ansprüche 1 bis 4, **dadurch gekennzeichnet, dass** zumindest zwei miteinander über den Licht-Wellenleiter (6) verbundene optoelektronische Bauelemente (4, 5; 4', 5') in der optischen Schicht (3) eingebettet sind.

6. Leiterplattenelement nach einem der Ansprüche 1 bis 5, **dadurch gekennzeichnet, dass** das optoelektronische Bauelement (5) mit einer zugehörigen elektronischen Komponente (14) zu einer eingebetteten Baueinheit (514) vereinigt ist, die beispielsweise ein optoelektronischer Chip ist.

7. Leiterplattenelement nach einem der Ansprüche 1 bis 6, **dadurch gekennzeichnet, dass** die elektrisch leitende Verteilerschicht (21') mit wenigstens einem äußeren elektrischen Kontakt, vorzugsweise über eine Via-Bohrung (22) im Substrat (7'), verbunden ist.

8. Leiterplattenelement nach einem der Ansprüche 1 bis 7, **dadurch gekennzeichnet, dass** der Licht-Wellenleiter (6) am an das optoelektronische Bauelement (4) angrenzenden Ende (34) trichterförmig aufgeweitet oder mit einer photonischen Lichtbeugungs-Kristallstruktur (38) versehen ist, oder dass der Licht-Wellenleiter (6) mit seinem an das optoelektronische Bauelement (4) angrenzenden Ende (37; 39) das optoelektronische Bauelement (4) zumindest teilweise umschließt.

9. Verfahren zur Herstellung eines Leiterplattenelements (1) mit wenigstens einem in einer optischen Schicht (3) eingebetteten optoelektronischen Bauelement (4, 5; 4', 5') und mit wenigstens einem in der optischen Schicht (3) vorgesehenen Licht-Wellenleiter (6), der an das optoelektronische Bauelement (4, 5; 4', 5') anschließt, **dadurch gekennzeichnet, dass** auf einem Substrat eine elektrisch leitende Überzugsschicht als Verteiler- bzw. Wärmeableitschicht (21') aufgebracht wird, dass auf dem Substrat (2) zumindest ein optoelektronisches Bauelement (4, 5; 4', 5') angebracht wird, dass danach auf das Substrat eine einzelne, durch photoreaktives, Zweiphotonenabsorptions-Prozess-fähiges Material gebildete optische Schicht (3), die unter Photonenbestrahlung ihren Brechungsindex ändert, aufgebracht wird, wobei das optoelektronische Bauelement (4, 5; 4',5') in der optischen Schicht (3) eingebettet wird, und dass danach in der optischen Schicht (3) durch einen Zweiphotonenabsorptions-Prozess eine an das optoelektronische Bauelement (4, 5; 4', 5') anschließende optische Wellenleiterstruktur (6) erzeugt wird.

10. Verfahren nach Anspruch 9, **dadurch gekennzeichnet, dass** die Verteiler- bzw. Wärmeableitschicht (21') strukturiert wird, wobei vorzugsweise elektrische Anschlüsse für das optoelektronische Bauelement (4, 5) über die Verteilerschicht hergestellt werden.

11. Verfahren nach Anspruch 9 oder 10, **dadurch gekennzeichnet, dass** zumindest zwei optoelektronische Bauelemente (4, 5; 4', 5') auf dem Substrat (2) angebracht sowie in der optischen Schicht (3) eingebettet und danach durch die direkt an sie anschließende optische Wellenleiterstruktur (6) miteinander verbunden werden.

12. Verfahren nach einem der Ansprüche 9 bis 11, **dadurch gekennzeichnet, dass** nach der Erzeugung der optischen Wellenleiterstruktur (6) in der optischen Schicht (3) auf zumindest einer Seite dieser optischen Schicht (3) eine Leiterplattenschicht (7, 7') mit einer leitenden Innen- (21, 21') und bzw. oder Außenlage (9, 9') aufgebracht wird, wobei die Innenlage (21, 21') vorzugsweise vor der Aufbringung der Leiterplattenschicht auf der optischen Schicht strukturiert wird.

13. Verfahren nach Anspruch 12, **dadurch gekennzeichnet, dass** die Außenlage (9, 9') nach der Aufbringung der Leiterplattenschicht auf der optischen Schicht strukturiert wird.

14. Verfahren nach einem der Ansprüche 11 bis 13, **dadurch gekennzeichnet, dass** in der optischen Schicht (3), gegebenenfalls auch in der Leiterplattenschicht (7, 7'), in Zuordnung zum optoelektronischen Bauelement (4, 5; 4', 5') Via-Bohrungen (22) angebracht und über diese elektrisch leitende Verbindungen zum optoelektronischen Bauelement hergestellt werden, wobei vorzugsweise auf der Leiterplattenschicht (7) und bzw. oder auf dem Substrat zumindest eine elektronische Komponente (13, 14) angebracht wird, die mit dem optoelektronischen Bauelement (4, 5) leitend verbunden wird.

15. Verfahren nach einem der Ansprüche 9 bis 14, **dadurch gekennzeichnet, dass** ein mit einer zugehörigen elektronischen Komponente (14) zu einer Baueinheit kombiniertes optoelektronisches Bauelement (5) auf dem Substrat aufgebracht und in der optischen Schicht eingebettet wird.

16. Verfahren nach einem der Ansprüche 9 bis 15, **dadurch gekennzeichnet, dass** das Substrat (3) mit mindestens einer Überzugsschicht (3'; 21), vorzugsweise aus optischem Material, versehen wird, bevor das optoelektronische Bauelement (4, 5) darauf aufgebracht wird.

17. Verfahren nach einem der Ansprüche 9 bis 16, **dadurch gekennzeichnet, dass** das optoelektronische Bauelement (4, 5) in Dünnschichttechnik in situ auf dem Substrat (3) erzeugt wird.

18. Verfahren nach einem der Ansprüche 9 bis 17, **dadurch gekennzeichnet, dass** die optische Wellenleiterstruktur (6) mit einer trichterförmigen Erweiterung (37) oder mit einer photonischen Lichtbeugungs-Kristallstruktur (38) am an das optoelektronische Bauelement (4) angrenzenden Ende erzeugt wird, oder dass die optische Wellenleiterstruktur (6) mit einem das optoelektronische Bauelement (4) zumindest teilweise umschließenden Endbereich (37; 39) erzeugt wird.
